(19) Europäisches Patentamt

European Patent Office

Office européen des brevets

(11) Veröffentlichungsnummer: **0 407 905 A2**

# (12) EUROPÄISCHE PATENTANMELDUNG

(21) Anmeldenummer: 90112912.2

(22) Anmeldetag: 06.07.90

(51) Int. Cl.5: **H01L 23/373, H01L 23/13**

(30) Priorität: 08.07.89 DE 3922485

(43) Veröffentlichungstag der Anmeldung:
**16.01.91 Patentblatt 91/03**

(84) Benannte Vertragsstaaten:
**DE FR GB IT**

(71) Anmelder: **DODUCO GMBH + Co Dr. Eugen Dürrwächter**
**Im Altgefäll 12**
**D-7530 Pforzheim(DE)**

(72) Erfinder: **Waibel, Brigitte**
**Friedenstrasse 44**
**D-7530 Pforzheim(DE)**
Erfinder: **Martin, Wolfram, Dipl.-Phys.**
**Amselweg 11**
**D-7534 Birkenfeld(DE)**

(74) Vertreter: **Twelmeier, Ulrich, Dipl.Phys. et al**
**Westliche Karl-Friedrich-Strasse 29-31**
**D-7530 Pforzheim(DE)**

(54) **Flacher Körper, insbesondere zur Verwendung als Wärmesenke für elektronische Leistungsbauelemente.**

(57) Der flache Körper besteht aus einer Keramikplatte (1), welche auf ihrer einen Seite von einer ersten Metallplatte (2) und auf ihrer anderen Seite von einer zweiten Metallplatte (3) bedeckt ist, die auf ihrer gesamten Auflagefläche fest mit der Keramikplatte (1) verbunden sind. Die erste Metallplatte (2) hat eine eine nicht bis zur Oberfläche der Keramikplatte (1) reichende, flache Vertiefung (5) zur Aufnahme eines elektronischen Leistungsbauelementes. Der Körper dient als Wärmesenke für ein Leistungsbauelement.

Fig.2

EP 0 407 905 A2

# FLACHER KÖRPER, INSBESONDERE ZUR VERWENDUNG ALS WÄRMESENKE FÜR ELEKTRONISCHE LEISTUNGSBAUELEMENTE

Die Erfindung geht aus von einem flachen Körper mit den im Oberbegriff des Anspruchs 1 angegebenen Merkmalen. Ein solcher Körper ist aus der DE-37 28 096 C1 bekannt. Er besteht aus einer dünnen Keramikplatte, zumeist aus Aluminiumoxid, welche beidseitig mit je einer Metallplatte, üblicherweise aus Kupfer, bedeckt ist. Er dient als Wärmesenke für elektronische Leistungsbauelemente, z.B. in Zündvorrichtung für Ottomotoren in Automobilen.

Die Leistungsbauelemente werden direkt auf eine der Metallplatten gelötet. Dazu bedient man sich üblicherweise einer Lötmaske als Hilfsmittel, die das Leistungsbauelement während des Lötvorganges in der gewünschten Position fixiert. Nachteilig ist dabei, dass man zunächst die Lötmaske positionieren und fixieren muss. Die Lötmaske kann nach dem Lötvorgang entfernt werden; nachteilig dabei ist, dass das nur mit großer Vorsicht geschehen kann, um das Leistungsbauelement nicht zu beschädigen. Es ist aber auch möglich, die Lötmaske zusammen mit dem Leistungsbauelement auf die Metallplatte zu löten und sie darauf zu belassen (sogenannte verlorene Lötmaske). Nachteilig dabei ist, dass man sich stets Probleme mit der Anpassung der mechanischen Eigenschaften der Lötmaske an die mechanischen Eigenschaften der Metallplatte einhandelt. Verwendet man wie allgemein üblich Metallplatten aus Kupfer, welche ohne eine Zwischenschicht mit der Keramikplatte verbunden sind (Direct-Bonding-Verfahren), dann sind die Metallplatten ausserordentlich weich, weil das Direct-Bonding-Verfahren dicht unterhalb des Schmelzpunktes durchgeführt wird. Das auf die Keramikplatte gebondete Kupfer hat danach nur noch einen effektiven linearen Wärmeausdehnungskoeffizienten von $7,5 \times 10^{-6}$ bis $10 \times 10^{-6}$ $K^{-1}$. Verwendet man als verlorene Lötmaske z.B. ein Kupfer- oder Nickelblech, so hat dieses einen linearen Wärmeausdehnungskoeffizienten von ungefähr $16 \times 10^{-6}$ $K^{-1}$, was bei Temperaturänderungen zu Zug- bzw. Druckspannungen parallel zur Oberfläche führt, die zu einem Bruch in der Keramikplatte parallel zur Oberfläche (Muschelbruch) führen können. Entsprechendes gilt bei Werkstoffen mit kleinerem linearen Wärmeausdehnungskoeffizienten, wie z.B. aus Nickel-Eisen-Legierungen (Kovar), dann erhält man einen unerwünschten Bimetalleffekt.

Der Erfindung liegt die Aufgabe zugrunde, das Auflöten von elektronischen Leistungsbauelementen auf flache Körper der eingangs genannten Art zu erleichtern, ohne deren Temperaturwechselbeständigkeit zu verschlechtern.

Diese Aufgabe wird gelöst durch flache Körper mit den im Anspruch 1 angegebenen Merkmalen. Vorteilhafte Weiterbildungen der Erfindung sind Gegenstand der Unteransprüche.

Bei Verwendung der erfindungsgemäßen Körper kommt man ohne eine gesonderte Lötmaske aus, da in einer der beiden Metallplatten eine flache Vertiefung ausgebildet ist, welche die Aufgabe einer Lötmaske übernimmt. Die mit der Vertiefung versehene Metallplatte besteht unverändert homogen aus ein und demselben Werkstoff, insbesondere aus Kupfer, so dass anders als bei Verwendung der be kannten verlorenen Lötmasken keine zusätzlichen Spannungen in den Körper eingebracht werden, die zu unterschiedlichen Druck-, Zug- und/oder Biegebeanspruchungen führen würden. Dadurch, dass die Lötmaske von vornherein in eine der Metallplatten integriert ist, entfallen beim Anwender auch die bislang erforderlichen Arbeitsschritte zum Positionieren der Lötmasken; vielmehr kann der Anwender die Leistungsbauelemente unmittelbar in der Vertiefung der einen Metallplatte positionieren und durch Löten fixieren.

Vorzugsweise bemißt man die Metallplatten so, dass die zweite Metallplatte dicker ist als die erste Metallplatte im Bereich ihrer Vertiefung, aber dünner als die erste Metallplatte in ihrem Bereich mit unverminderter Dicke, so dass die Massenbelegung der Keramikplatte mit dem Metall auf ihrer einen Seite gleich oder annähernd gleich ist wie auf der anderen Seite. Ausserdem sollten die beiden Metallplatten am besten aus demselben Metall bestehen und deckungsgleich angeordnet sein. Man hat dann auf beiden Seiten Metallplatten mit übereinstimmender Wärmekapazität, was für eine gleichmässige Wärmeableitung aus den Leistungsbauelementen sowie für deren Fixierung während des Lötvorganges von Vorteil ist. Eine Durchbiegung der Keramikplatte aufgrund des Aufbringens unterschiedlich dicker Metallplatten, von denen - wie gesagt - die mit der Vertiefung versehene etwas dicker ist als die auf der gegenüberliegenden Seite der Keramikplatte, kann mit Vorteil dadurch vermieden werden, dass man die erste, mit der Vertiefung versehene Metallplatte, mit Randstreifen versieht, die eine verminderte Dicke haben.

Vorzugsweise ist der Randstreifen mit verminderter Dicke umlaufend vorgesehen, aber auch bereits zwei gegenüberliegende Randstreifen mit verminderter Dicke bringen in dieser Hinsicht einen positiven Effekt. Zusätzlich besteht die Möglichkeit, ausserhalb der Vertiefung für das Leistungsbauelement weitere kleinere Vertiefungen in der ersten Metallplatte vorzusehen, um eine Durchbiegung der Keramikplatte zu verhindern.

Die Vertiefung für das Leistungsbauelement kann auf unterschiedliche Weise gebildet werden, beispielsweise durch Elektroerosion oder durch einen Ätzvorgang. Es ist auch möglich, die erste Metallplatte zweischichtig aufzubauen aus einer gleichmässig dicken Grundplatte und einer gleichmässig dicken Deckplatte aus demselben Metall, wobei die Deckplatte zur Bildung der Vertiefung eine bis zur Grundplatte reichende Ausnehmung hat. Man kann dann die zur Bildung der ersten Metallplatte verwendeten Deck- und Grundplatten, die Keramikplatte und die zweite Metallplatte aufeinanderschichten und in einem Arbeitsgang durch ein Direct-Bonding-Verfahren miteinander verbinden, wodurch die zweischichtige erste Metallplatte in ihren mechanischen Eigenschaften homogen erhalten wird. Besonders einfach und preisgünstig ist es jedoch, die erste Metallplatte einem Prägevorgang zu unterwerfen, durch welchen die Vertiefung gebildet wird und ggfs. auch die Randstreifen mit verminderter Dicke ausgebildet werden können. Das Formen der ersten Metallplatte kann vor dem Verbinden mit der Keramikplatte oder nach dem Verbinden mit der Keramikplatte erfolgen. Vorzugsweise erfolgt es vor dem Verbinden mit der Keramikplatte.

Ein Ausführungsbeispiel der Erfindung wird anhand der beigefügten Zeichnung näher erläutert, die in

Figur 1 einen flachen Körper in der Draufsicht in

Figur 2 denselben flachen Körper in einem Längsschnitt und in

Figur 3 einen Körper in einer Darstellung wie in Figur 2, jedoch mit einer zweischichtigen Metallplatte zeigt.

Der Körper besteht aus einer dünnen, rechteckigen Keramikplatte 1, vorzugsweise aus Aluminiumoxid, mit deren Oberseite eine erste Metallplatte 2 und mit deren Unterseite eine zweite Metallplatte 3 direkt verbunden ist. Die Metallplatten 2 und 3 bestehen aus demselben Metall, vorzugsweise aus Kupfer, sind rechteckig ausgebildet, etwas kleiner als die Keramikplatte 1 und mittig auf der Keramikplatte 1 angeordnet, so dass zwischen den Metallplatten 2 und 3 ein Randstreifen 4 der Keramikplatte übersteht. Die Metallplatten 2 und 3 sind im Umriß gleich und sind deckungsgleich angeordnet; ihre Dicke liegt in ähnlicher Größenordnung wie die Dicke der Keramikplatte 1.

In der ersten Metallplatte 2 ist eine flache Vertiefung 5 ausgebildet, welche nicht bis zur Oberfläche der Keramikplatte 1 herabreicht.

Die Dicke $d_2$ der zweiten Metallplatte ist etwas geringer als die Dicke $d_1$ der ersten Metallplatte im Bereich ausserhalb der Vertiefung 5, aber größer als die restliche Dicke $d_3$ der ersten Metallplatte im Bereich der Vertiefung. Zum Ausgleich von Wärmespannungen, welche dadurch entstehen könnten, dass die erste Metallplatte 2 dicker ist als die zweite Metallplatte 3, hat die erste Metallplatte 2 umlaufend einen Randstreifen 6 mit verminderter Dicke; die Breite dieses Randstreifens beträgt mindestens 0,5 mm, vorzugsweise ungefähr 1 mm. Die Tiefe der Vertiefung 5 beträgt vorzugsweise zwischen 0,15 mm und 0,30 mm. Die Keramikplatte ist mindestens 0,10 mm, vorzugsweise 0,50 bis 0,80 mm dick. Die zweite Metallplatte 3 sollte mindestens 0,30 mm, vorzugsweise 0,50 mm bis 0,80 mm dick sein. Die erste Metallplatte ist - wie gesagt - insgesamt etwas dicker als die zweite Metallplatte 3, stimmt jedoch in ihrer Masse vorzugsweise mit der Masse der zweiten Metallplatte überein.

Ein besonders geeignetes Ausführungsbeispiel hat folgende Daten:

Die Keramikplatte 1 besteht aus einer Oxidkeramik oder aus einer Keramik mit oxidischer Oberfläche, insbesondere aus Aluminiumoxid, mit den Abmessungen 23 mm x 13 mm x 0,63 mm.

Die zweite Metallplatte besteht aus Kupfer und hat die Abmessungen 21 mm x 11 mm x 0,65 mm. Die erste Metallplatte besteht ebenfalls aus Kupfer und ist wie die zweite Metallplatte 21 mm lang und 11 mm breit; ihre Dicke $d_1$ beträgt 0,75 mm, die Tiefe der Vertiefung 5 beträgt 0,20 mm, die restliche Dicke $d_3$ beträgt deshalb 0,55 mm und ist zugleich die Dicke des Randstreifens 6, der umlaufend eine Breite von 1 mm hat. Der Umriß der Vertiefung 5 richtet sich nach der Größe des aufzunehmenden Bauelementes und könnte z.B. 5,4 mm x 5,4 mm betragen.

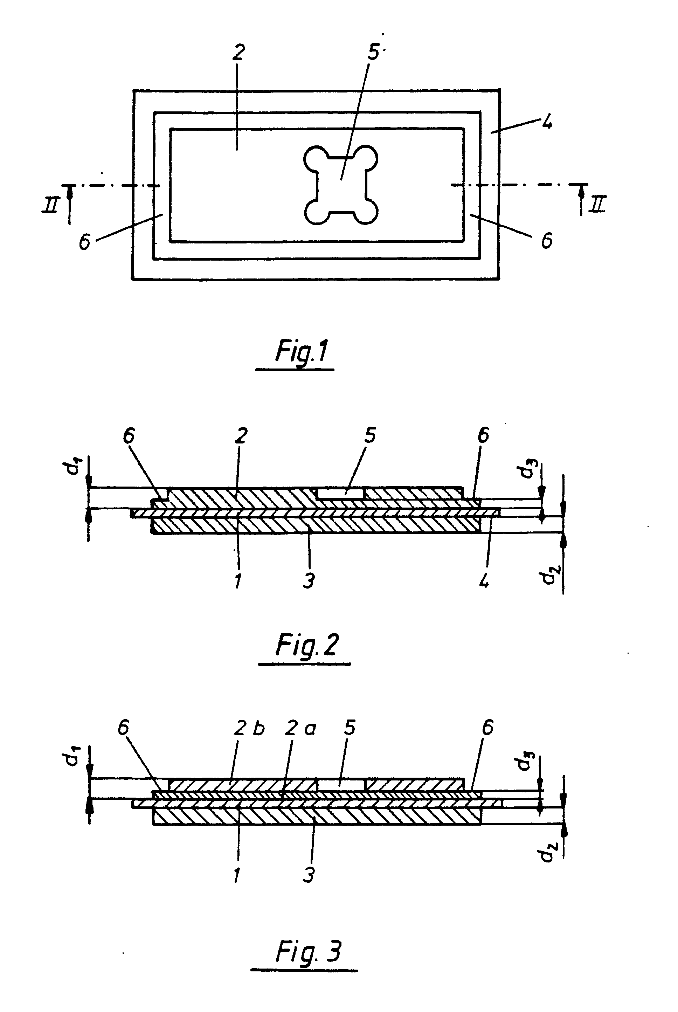

Das in der Figur 3 dargestellte Ausführungsbeispiel unterscheidet sich von dem in Figur 2 dargestellten darin, dass die erste Metallplatte 2 zweischichtig aufgebaut ist und aus einer Grundplatte 2a und aus einer Deckplatte 2b besteht, die ohne Zwischenschicht miteinander verbunden sind. Die Grundplatte 2a ist eine Platte mit gleichmässiger Dicke. Die Deckplatte 2b hat zur Bildung der Vertiefung eine durchgehende Ausnehmung und ist zur Bildung der Randstreifen 6 mit verminderter Dicke in Länge und Breite etwas kleiner als die Grundplatte 2a.

**Ansprüche**

1. Flacher Körper, insbesondere zur Verwendung als Wärmesenke für elektronische Leistungsbauelemente, bestehend aus einer Keramikplatte (1), welche auf ihrer einen Seite von einer ersten Metallplatte (2) und auf ihrer anderen Seite von einer zweiten Metallplatte (3) bedeckt ist, die auf ihrer gesamten Auflagefläche fest mit der Keramikplatte (1) verbunden sind,
**dadurch gekennzeichnet,** dass die erste Metallplatte (2) eine nicht bis zur Oberfläche der Keramikplatte (1) reichende flache Vertiefung (5) hat.

2. Körper nach Anspruch 1, **dadurch gekennzeichnet,** dass die zweite Metallplatte (3) dicker als die erste Metallplatte (2) im Bereich ihrer Vertiefung (5), aber dünner ist als die erste Metallplatte (2) in ihrem Bereich mit unverminderter Dicke.

3. Körper nach Anspruch 1 oder 2, **dadurch gekennzeichnet,** dass die beiden Metallplatten (2, 3) aus demselben Metall bestehen.

4. Körper nach Anspruch 3, **dadurch gekennzeichnet,** dass die beiden Metallplatten (2, 3) deckungsgleich angeordnet und in ihrer Dicke so bemessen sind, dass ihre Massen gleich oder annähernd gleich sind.

5. Körper nach einem der vorstehenden Ansprüche, **dadurch gekennzeichnet,** dass wenigstens die erste Metallplatte (2) Randstreifen (6) mit verminderter Dicke hat.

6. Körper nach einem der vorstehenden Ansprüche, **dadurch gekennzeichnet,** dass die erste Metallplatte (2) zweischichtig aufgebaut ist und aus einer gleichmässig dicken Grundplatte (2a) und einer gleichmässig dicken Deckplatte (2b) besteht, die zur Bildung der Vertiefung (5) eine bis zur Grundplatte (2a) reichende Ausnehmung hat.

7. Körper nach Anspruch 5, **dadurch gekennzeichnet,** dass die Grundplatte (2a) und die Deckplatte (2b) ohne Zwischenschicht miteinander verbunden sind.

8. Körper nach Anspruch 6 oder 7, **dadurch gekennzeichnet,** dass die Deckplatte (2b) dünner als die Grundplatte (2a) ist.

9. Körper nach Anspruch 8, **dadurch gekennzeichnet,** dass die Deckplatte (2b) 0,15 bis 0,3 mm dick ist.

10. Körper nach einem er Ansprüche 6 bis 9, **dadurch gekennzeichnet,** dass die Deckplatte (2b) eine kleinere Länge und/oder Breite als die Grundplatte (2a) hat.

11. Verfahren zum Herstellen eines Körpers nach Anspruch 6 mit Metallplatten aus Kupfer, **dadurch gekennzeichnet,** dass die drei Metallplatten (2a, 2b, 3) und die Keramikplatte (1) ohne Zwischenschichten aufeinandergelegt und gleichzeitig unter Anwendung eines Direct-Copper-Bonding-Verfahrens (DCB-Verfahren) miteinander verbunden werden.

12. Verfahren zum Herstellen eines Körpers nach Anspruch 1, **dadurch gekennzeichnet,** dass die Vertiefung (5) in die erste Metallplatte (2) eingeprägt wird.

13. Verfahren nach Anspruch 12 und 5, **dadurch gekennzeichnet,** dass auch die Randstreifen (6) mit verminderter Dicke durch Prägen gebildet werden.

14. Verfahren zum Herstellen eines Körpers nach Anspruch 1, **dadurch gekennzeichnet,** dass die Vertiefung (5) in der ersten Metallplatte (2) durch

Ätzen gebildet wird.

_Fig.1_

_Fig.2_

_Fig. 3_